(19) Europäisches Patentamt
European Patent Office
Office européen des brevets

(11) EP 1 401 987 B1

(12) EUROPEAN PATENT SPECIFICATION

(45) Date of publication and mention of the grant of the patent:
**09.02.2005 Bulletin 2005/06**

(21) Application number: **02739595.3**

(22) Date of filing: **31.05.2002**

(51) Int Cl.[7]: **C09K 5/06**

(86) International application number:
**PCT/US2002/017343**

(87) International publication number:
**WO 2003/004580 (16.01.2003 Gazette 2003/03)**

# (54) THERMOCONDUCTIVE COMPOSITION

WÄRMELEITENDE ZUSAMMENSETZUNG

COMPOSITION THERMOCONDUCTRICE

(84) Designated Contracting States:
**AT BE CH CY DE DK ES FI FR GB GR IE IT LI LU MC NL PT SE TR**

(30) Priority: **02.07.2001 JP 2001201295**

(43) Date of publication of application:
**31.03.2004 Bulletin 2004/14**

(73) Proprietor: **3M Innovative Properties Company**
**St. Paul, MN 55133-3427 (US)**

(72) Inventors:
- **YAMAZAKI, Yoshinao**
  **Yokohama-city, Kanagawa 227-0034 (JP)**
- **OKADA, Mitsuhiko**
  **Chofu-city, Tokyo 182-0024 (JP)**
- **TANZAWA, Tomoya**
  **Sagamihara-city, Kanagawa 229-1133 (JP)**

(74) Representative: **VOSSIUS & PARTNER**
**Siebertstrasse 4**
**81675 München (DE)**

(56) References cited:
**EP-A- 1 067 164**
**EP-A- 1 094 516**
**US-A- 6 054 198**
**US-B1- 6 197 859**

- **DATABASE WPI Section Ch, Week 199330 Derwent Publications Ltd., London, GB; Class A97, AN 1993-240194 XP002215249 & JP 05 163485 A (MITSUBISHI CABLE IND LTD), 29 June 1993 (1993-06-29)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 401 987 B1

Printed by Jouve, 75001 PARIS (FR)

## Description

### TECHNICAL FIELD

The present invention relates to a thermoconductive composition, and more particularly, to a thermoconductive composition useful for closely contacting to a central processing unit (CPU) and other exothermic electronic components and releasing their heat to the outside.

### BACKGROUND

The removal of heat from exothermic bodies is important in certain fields. For example, the removal of heat from electronic components (e.g., integrated circuit (IC) chips) and other components (to be generically referred to as "exothermic components") contained in electronic devices, personal computers and various other devices is important because, as the temperature of exothermic components rise, the probability of a component malfunctioning tends to increase exponentially. Additionally, reductions in the size of electronic components and increases in processing speeds have added to the requirements being placed on electronic exothermic components.

At present, in order to dissipate heat from exothermic components, heat radiators such as heat sinks, radiating fins and metal heat spreaders are often attached to the exothermic components. Alternatively, various thermoconductive materials or sheets are used as heat transfer spacers between exothermic components and heat radiators to enable them to act as heat transfer media.

The use of grease has been proposed as a thermoconductive material. Although silicone-based grease has demonstrated superior thermal conductivity, it is a liquid. Consequently, disposing the silicone grease between exothermic components and heat radiators has been problematic. One type of thermoconductive material is described in United States Patent No. 4,299,715 ('715 patent), describing a thermoconductive material comprising a wax and petroleum jelly. The material is a semi-solid at room temperature and can be formed into various shapes. In order to provide this composition into a form comparable to the present invention, it would be necessary to coat the composition onto a carrier due to the insufficient strength of the composition. However, the presence of the carrier will cause a decrease in heat radiation characteristics.

Japanese Unexamined Patent Publication No. 2000-336279 describes a thermoconductive composition that comprises a wax and thermoconductive filler and is formed into a sheet. When forming a sheet of the composition, it is necessary to coat the composition onto a carrier such as a glass cloth or a carrier film. Like the foregoing composition of the '715 patent, the carrier interferes with the compositions ability to provide satisfactory heat radiation characteristics.

Japanese Unexamined International Patent Publication No. 2000-509209 describes a thermoconductive composition that uses a wax comprised of a complex of a microcrystalline component and an amorphous component. Although a form is indicated in the examples that does not use a carrier to prevent a decrease in heat radiation characteristics, due to the low level of crystalline component of the composition, the composition itself is extremely brittle so that even if a sheet is formed without using a carrier, the resulting sheet does not have satisfactory strength or liner separation.

Japanese Unexamined Patent Publication No. 2001-89756 describes a thermoconductive composition containing a polymer component, wax and thermoconductive filler. Although this composition is provided in the form of strips having adequate strength, it has the problem of inferior heat radiation characteristics because it uses elastomer as a polymer component. The elastomeric component decreases fluidity on melting.

An object of the present invention is to provide a thermoconductive composition that solves the above problems, can be provided as a sheet of material and demonstrates high thermal conductivity and adequate strength.

### SUMMARY OF THE INVENTION

The present invention provides a thermoconductive composition comprising:

(a) 100 parts by weight of wax,
(b) 10 to 1,000 parts by weight of the compound of the above-mentioned formula (I)

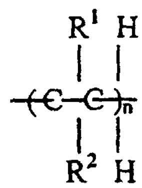

(I)

where $R^1$ and $R^2$ independently represent an alkyl group having 1 to 3 carbons, and n represents a value of 100 to 100,000,

(c) 10 to 2,000 parts by weight of a thermoconductive filler and

(d) 0 to 1,000 parts by weight of a softener.

In another aspect, the invention provides an article comprising:

(a) an exothermic component;

(b) a heat radiator; and

(c) the foregoing thermoconductive composition disposed between the exothermic component and the heat radiator.

**DETAILED DESCRIPTION OF THE PREFERRED EMBODIMENT**

The thermoconductive composition of the present invention is composed by blending 10 to 1,000 parts by weight of the compound of the formula (I) together with 10 to 2,000 parts by weight of a thermoconductive filler; 0 to 1,000 parts by weight of a softener and 100 parts by weight of wax.

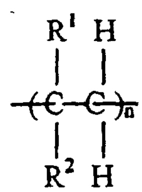

(I)

where $R^1$ and $R^2$ independently represent an alkyl group having 1 to 3 carbons, and n represents a value of 100 to 100,000.

There are no particular restrictions on the wax, and natural wax, synthetic wax, blended wax or the like can all be used. Examples of natural waxes include plant waxes such as candelilla wax, carnauba wax, rice wax, haze wax and hohoba oil; animal waxes such as beeswax, lanolin and spermaceti; mineral waxes such as montan wax, ozokerite and ceresin; and, petroleum waxes such as paraffin wax, microcrystalline wax and petrolactam. Examples of synthetic waxes include synthetic hydrocarbons such as Fischer-Tropsch wax and polyethylene wax; denatured waxes such as montax wax derivatives, paraffin wax derivatives and microcrystalline wax derivatives; hydrogenated waxes such as cured castor oil and cured castor oil derivatives; as well as fatty acids, acid amides, esters, ketones and others such as 12-hydroxystearic acid, stearic amide, anhydrous phthalic imide and chlorinated hydrocarbons. The melting point of this wax is preferably 30 to 150°C, and more preferably 40 to 80°C.

In the compound of the above formula (I), $R^1$ and $R^2$ are both preferably methyl groups. Namely, the compound of formula (I) is preferably polyisobutylene. The number of repeating units n is preferably 100 to 100,000, and the molecular weight is preferably 1,000 to 1,000,000, and more preferably 30,000 to 60,000. The amount of the compound of formula (I) present in the thermoconductive composition is 10 to 1,000 parts by weight, and preferably 20 to 100 parts by weight, relative to 100 parts by weight of wax.

It was found that when the compound of formula (I) is a liquid polymer having a flow temperature above room temperature, as defined by JISK 2269, a thermoconductive composition containing this compound has unique effects. In this context, "liquid" refers to a material having maximum strain when an amount of stress is applied. In prior compositions, a composition containing wax alone as a binder component has exhibited poor sheet strength and is typically difficult to handle. A composition containing an elastomer, such as rubber, acrylic, silicone, and the like and wax as a binder component has good sheet strength, but heat radiation characteristics are inferior because an elastomeric component decreases fluidity on melting. Further, a composition containing a low molecular weight resin, such as a thickener, or a liquid polymer having a flow temperature above a room temperature, such as liquid polybutene, and

wax as a binder component is difficult to handle because tackiness of a sheet becomes too high or a coherent of a sheet decreases. On the other hand, the composition of the present invention which contains wax and a compound of formula (I) as a binder component has good fluidity on melting because it does not contain a elastomeric component, and has good heat radiation characteristics. Further, the thermoconductive composition of the present invention does not produce an excess tackiness. However, it does decrease the brittleness of a sheet, and has good sheet strength, and therefore has good handling properties.

There are no particular restrictions on the thermoconductive filler provided it disperses uniformly throughout when forming a sheet and is able to provide a thermoconductive sheet with a prescribed level of thermal conductivity. Various types of fillers used in the prior art as fillers in the production of thermoconductive sheets can be used. Examples of suitable thermoconductive fillers include oxide particles such as aluminum oxide, silicon dioxide, titanium oxide, mica, potassium titanate, iron oxide and talc; nitride particles such as boron nitride, silicon nitride and aluminum nitride; carbon particles such as silicon carbide; and metal particles such as copper and aluminum. The thermoconductive filler may be used alone or as a mixture of two or more types. The mean particle size of the thermoconductive filler used in the present invention is preferably 0.1 to 100 $\mu$m, and more preferably 1 to 20 $\mu$m. The amount of thermoconductive filler is 10 to 2,000 parts by weight, and preferably 20 to 200 parts by weight, relative to 100 parts by weight of wax. If the amount of thermoconductive filler is less than 10 parts by weight, it is difficult to obtain adequate thermal conductivity, while conversely if the amount exceeds 2,000 parts by weight, it is difficult to uniformly disperse the thermoconductive filler, the fluidity of the wax is lowered, which makes it difficult to form a sheet.

Although a softening agent does not necessarily have to be added, addition of softening agent improves the fluidity of the thermoconductive composition, and improves close contact between the exothermic component and heat radiator, thereby making it possible to further enhance thermal conductivity. In addition, a thermoconductive composition to which softening agent has been added is able to have desired tackiness when attaching to an exothermic component or heat radiator. Examples of softening agents that can be used include plant-based softening agents, mineral oil-based softening agents and synthetic plasticizers that are compatible with wax. Examples of plant-based softening agents that can be used include cottonseed oil, linseed oil and rape seed oil. Examples of mineral oil-based softening agents include paraffin oils, naphthene oils and aromatic oils. Examples of synthetic plasticizers that can be used include dioctyl phthalate, dibutyl phthalate, dioctyl adipate, isodecyl adipate, dioctyl sebacate and dibutyl sebacate. Among these, naphthene oils and paraffin oils are particularly preferable. The blended amount of softening agent present in the composition of the invention is 0 to 1,000 parts by weight, and preferably 0 to 10 parts by weight, relative to 100 parts by weight of wax.

Various types of additives routinely used in the field of polymer chemistry can also be added to the thermoconductive composition of the present invention in addition to the above components. For example, tackifier or plasticizer and so forth may be added to adjust the tackiness of the formed sheet, or flame retardant or antioxidant may be added to enhance heat resistance. Examples of other additives that may be added include modifiers, heat stabilizers and colorants. In addition, the above thermoconductive filler may be treated with a surface treatment agent such as a silane coupling agent.

The thermoconductive composition of the present invention can be produced by mixing prescribed amounts of each of the above components. The thermoconductive composition can be formed into a sheet or film in accordance with known methods in the relevant field. For example, wax, the compound of formula (I), thermoconductive filler and a prescribed softening agent may be kneaded with a heated mixer, and the mixture then formed into a sheet by coating onto a liner by hot melt coating. Alternatively, the above materials may be dissolved in a suitable solvent, mixed with a mixer and formed into a sheet by coating onto a liner by solvent casting.

Although the sheet prepared from the thermoconductive composition of the present invention can be made to be of various thicknesses according to the purpose of its use and its application site, in general, it is preferably as thin as possible, preferably having a thickness of 0.02 to 2.0 mm, and more preferably 0.1 to 0.5 mm. If the thickness is less than 0.02 mm, it is difficult to obtain close contact between the exothermic component and heat radiator. As a result, it is not possible to obtain adequate heat radiation characteristics. On the other hand, if the thickness of the sheet exceeds 2.0 mm, the amount that protrudes from the attachment surfaces of the exothermic component and heat radiator may increase and may result in the occurrence of unnecessary adhesion to surrounding components.

A thermoconductive sheet formed in this manner can be used directly as a heat transfer means if so desired. However, this sheet can also be used in combination with a suitable base material as desired. Examples of suitable base materials include plastic film, woven fabric, non-woven fabric and metal foil. Examples of woven fabric and non-woven fabric include those prepared from fibers of glass, polyester, polyolefin, nylon, carbon, ceramic and the like, andthe aforementioned fibers coated with a metal. The base material may be positioned on the surface of the sheet or as an interlayer.

The thermoconductive sheet is a solid at room temperature, and can be used by interposing between an exothermic component and heat radiator. The thermoconductive sheet has superior handling compared to using a liquid grease. The interposed thermoconductive sheet is softened by the heat of an exothermic component when that

exothermic component is operating, and fills in the gap between the exothermic component and a heat radiator. In addition, since the space between the exothermic component and heat radiator is quite small, the thermal resistance value of the thermoconductive sheet can be lowered considerably. Thus, the softening point of the thermoconductive composition that composes the thermoconductive sheet is preferably 30 to 150°C, and more preferably 40 to 100°C. The softening point can be set arbitrarily according to the type and amount of the constituent components used.

In addition, as a result of containing a prescribed amount of the compound of formula (I) in the thermoconductive composition of the invention, when compared to conventional sheets using wax, the strength of the thermoconductive sheet prepared therefrom is superior in tensile strength, bending strength and so forth, and can be used without the occurrence of problems such as tearing or cracking during use.

## EXAMPLES

Example 1

75 parts by weight of paraffin wax having a melting temperature of 54°C, 25 parts by weight of polyisobutylene having a weight average molecular weight of 40,000, and 50 parts by weight of boron nitride having a mean particle size of 10 μm were kneaded while heating followed by coating onto a liner to obtain a sheet having a thickness of 0.2 mm.

Example 2

69 parts by weight of paraffin wax having a melting temperature of 54°C, 23 parts by weight of polyisobutylene having a weight average molecular weight of 40,000, 8 parts by weight of naphthene oil having a weight average molecular weight of 300 and 50 parts by weight of boron nitride having a mean particle size of 10 μm were kneaded while heating followed by coating onto a liner to obtain a sheet having a thickness of 0.2 mm.

Comparative Example 1

100 parts by weight of paraffin wax having a melting temperature of 54°C, and 50 parts by weight of boron nitride having a mean particle size of 10 μm were kneaded while heating followed by coating onto a liner to obtain a sheet having a thickness of 0.2 mm.

Comparative Example 2

75 parts by weight of paraffin wax having a melting temperature of 54°C, 25 parts by weight of styrene-isobutylene copolymer (available from Shell under the trade designation "Kraton G1651"), and 50 parts by weight of boron nitride having a mean particle size of 10 μm were dissolved in 300 parts by weight of toluene followed by coating onto a liner and drying to obtain a sheet having a thickness of 0.2 mm.

Comparative Example 3

90 parts by weight of paraffin wax having a melting temperature of 54°C, 10 parts by weight of synthetic petroleum resin-based tackifier (available from Goodyear under the trade designation "Wingtack Plus") and 50 parts by weight of boron nitride having a mean particle size of 10 μm were dissolved in 300 parts by weight of toluene followed by coating onto a liner and drying to obtain a sheet having a thickness of 0.2 mm.

Evaluated Characteristics of Thermoconductive Sheets

Thermoconductive sheets produced in the manner described above were cut to a size of 10 mm x 11 mm and peeled from their liners. The sheets were interposed between an exothermic resistor and cooling aluminum plate followed by applying electrical power of 4.8 V to the exothermic resistor. After 5 minutes elapsed, the temperature of the exothermic resistor (T1) and the temperature of the aluminum plate (T2) were measured. The thermal resistance value was calculated according to the formula below.

$$\text{Thermal resistance } (^\circ C\ cm^2/W) = (T1-T2)(^\circ C) \times \text{sample surface area } (cm^2)/\text{electrical power } (W)$$

In addition, after peeling the sheets from their liners, functional evaluations were performed on their stretchability, bendability and ease of peeling from the liner. Namely, stretchability was evaluated by investigating the difficulty in tearing the sheet by stretching by hand in the left and right directions. Bendability was evaluated by investigating the difficulty in forming cracks by bending the sheet by hand. Ease of peeling from the liner was evaluated by investigating whether or not the sheet was easily peeled from the liner. The results of the above evaluations are shown in Table 1. Furthermore, liquid grease (available from Toray-Dow Coming Silicone Co. under the trade designation "SE4490CV') was used as Comparative Example 4.

Table 1

| | Thermal resistance value | Stretchability, bendability | Ease of peeling from liner |
|---|---|---|---|
| **Example 1** | 1.4 | pass | pass |
| **Example 2** | 1.3 | pass | pass |
| **Comp. Ex. 1** | 1.3 | fail | pass |
| **Comp. Ex. 2** | 3.0 | pass | pass |
| **Comp. Ex. 3** | 1.5 | pass | fail |
| **Comp. Ex. 4** | 1.3 | - | - |

As is clear from the above results, thermoconductive sheets formed using the composition of the present invention exhibited thermal conductivity nearly equal to that of thermoconductive sheets of the Comparative Examples and had significantly improved stretchability and other physical properties. Also, while the thermoconductive sheets of the Comparative Examples are easily torn or cracked when stretched or bent by hand or are difficult to peel from the liner, the thermoconductive sheets of the present invention were difficult to tear and exhibited superior handling characteristics.

As a result of using a compound of aforementioned formula (I), and preferably polyisobutylene, in addition to wax for the binder component of a composition containing a thermoconductive filler, the tensile strength, bending strength and so forth of a thermoconductive sheet formed from this composition can be enhanced without impairing the thermal conductivity of the sheet, thereby enabling handling characteristics to be improved.

## Claims

**1.** A thermoconductive composition comprising:

(a) 100 parts by weight of wax,
(b) 10 to 1,000 parts by weight of the compound of the following formula (I):

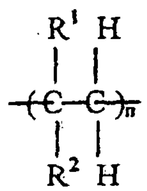

(I)

where, $R^1$ and $R^2$ independently represent an alkyl group having 1 to 3 carbons, and n represents a value of 100 to 100,000,
(c) 10 to 2,000 parts by weight of a thermoconductive filler and
(d) 0 to 1,000 parts by weight of a softener.

**2.** The composition of claim 1 wherein the compound of formula (I) is polyisobutylene.

**3.** The composition of claim 1 having a melting temperature of 30 to 150°C.

**4.** The composition of claim 1 that is formed in the form of a sheet.

**5.** The composition of claim 4 wherein the thickness of the sheet is 0.02 to 2. 0 mm.

**6.** The composition of claim 1 wherein the wax has a melting point of 30 to 150°C.

**7.** The composition of claim 1 wherein the wax is paraffin wax.

**8.** The composition of claim 1 wherein the softening agent is naphthene oil or paraffin oil.

**9.** The composition of claim 1 wherein the thermoconductive filler is boron nitride.

**10.** The composition of claim 4 wherein the sheet further comprises a base material.

**11.** An article comprising:

(a) an exothermic component;
(b) a heat radiator; and
(c) a thermoconductive composition of any of claims 1 to 10 disposed between the exothermic component and the heat radiator.

**12.** The article of claim 11 wherein the exothermic component is an electronic component.

**13.** The article of claim 12 wherein the electronic component is a central processing unit.

**14.** The article of claim 11 wherein the heat radiator is selected from the group consisting of a heat sink, a radiating fin, and a metal heat spreader.

**Patentansprüche**

**1.** Wärmeleitende Zusammensetzung umfassend:

(a) 100 Gewichtsteile Wachs,
(b) 10 bis 1.000 Gewichtsteile der Verbindung folgender Formel (I)

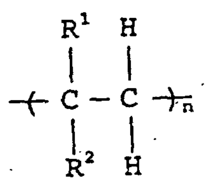

(I),

wobei $R^1$ und $R^2$ unabhängig eine Alkylgruppe darstellen, die 1 bis 3 Kohlenstoffatome besitzt, und n einen Wert von 100 bis 100.000 darstellt,
(c) 10 bis 2.000 Gewichtsteile eines wärmeleitenden Füllstoffs und
(d) 0 bis 1.000 Gewichtsteile eines Weichmachers.

**2.** Zusammensetzung nach Anspruch 1, wobei die Verbindung der Formel (I) Polyisobutylen ist.

**3.** Zusammensetzung nach Anspruch 1, die eine Schmelztemperatur von 30 bis 150 °C aufweist.

**4.** Zusammensetzung nach Anspruch 1, die in Form einer Folie gebildet ist.

**5.** Zusammensetzung nach Anspruch 4, wobei die Dicke der Folie 0,02 bis 2,0 mm beträgt.

6. Zusammensetzung nach Anspruch 1, wobei das Wachs einen Schmelzpunkt von 30 bis 150 °C aufweist.

7. Zusammensetzung nach Anspruch 1, wobei das Wachs Paraffinwachs ist.

8. Zusammensetzung nach Anspruch 1, wobei der Weichmacher Naphthenöl oder Paraffinöl ist.

9. Zusammensetzung nach Anspruch 1, wobei der wärmeleitende Füllstoff Bornitrid ist.

10. Zusammensetzung nach Anspruch 4, wobei die Folie des Weiteren ein Trägermaterial umfasst.

11. Gegenstand umfassend:

(a) eine exotherme Komponente;
(b) einen Wärmestrahler; und
(c) eine wärmeleitende Zusammensetzung nach einem der Ansprüche 1 bis 10, die zwischen der exothermen Komponente und dem Wärmestrahler angeordnet ist.

12. Gegenstand nach Anspruch 11, wobei die exotherme Komponente eine elektronische Komponente ist.

13. Gegenstand nach Anspruch 12, wobei die elektronische Komponente eine Zentraleinheit (CPU) ist.

14. Gegenstand nach Anspruch 11, wobei der Wärmestrahler aus der Gruppe ausgewählt ist bestehend aus einem Kühlkörper, einer Kühlrippe und einem Metallwärmeverteiler.

**Revendications**

1. Composition thermoconductrice comprenant :

(a) 100 parties pondérales de cire,
(b) entre 10 et 1 000 parties pondérales du composé ayant la formule suivante (I) :

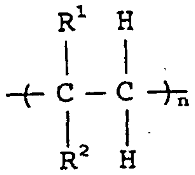

(I)

où $R^1$ et $R^2$ représentent indépendamment un groupe alkyle possédant entre 1 et 3 atomes de carbone, et n représente une valeur entre 100 et 100 000,
(c) entre 10 et 2 000 parties pondérales d'une charge thermoconductrice, et
(d) entre 0 et 1 000 parties pondérales d'un plastifiant.

2. Composition selon la revendication 1, dans laquelle le composé ayant la formule (I) est le polyisobutylène.

3. Composition selon la revendication 1, ayant une température de fusion entre 30 et 150°C.

4. Composition selon la revendication 1, travaillée de façon à former une feuille.

5. Composition selon la revendication 4, dans laquelle l'épaisseur de la feuille est entre 0,02 et 2,0 mm.

6. Composition selon la revendication 1, dans laquelle la cire a un point de fusion entre 30 et 150°C.

7. Composition selon la revendication 1, dans laquelle la cire est la cire de paraffine.

8. Composition selon la revendication 1, dans laquelle l'agent plastifiant est l'huile de naphtène ou l'huile de paraffine.

**9.** Composition selon la revendication 1, dans laquelle la charge thermoconductrice est le nitrure de bore.

**10.** Composition selon la revendication 4, dans laquelle la feuille comprend en outre un matériau de base.

**11.** Article comprenant :

(a) un composant exothermique ;
(b) un radiateur thermique ; et
(c) une composition thermoconductrice selon l'une quelconque des revendications 1 à 10, disposée entre le composant exothermique et le radiateur thermique.

**12.** Article selon la revendication 11, dans lequel le composant exothermique est un composant électronique.

**13.** Article selon la revendication 12, dans lequel le composant électronique est une unité centrale (CPU) de traitement.

**14.** Article selon la revendication 11, dans lequel le radiateur thermique est sélectionné dans le groupe constitué d'un dissipateur de chaleur, d'une ailette rayonnante, et d'un diffuseur de chaleur en métal.